(19) Europäisches Patentamt
European Patent Office
Office européen des brevets

(11) Veröffentlichungsnummer: **0 265 844 B1**

(12) **EUROPÄISCHE PATENTSCHRIFT**

(45) Veröffentlichungstag der Patentschrift: **28.08.91**

(51) Int. Cl.⁵: **H03K 17/95**, G01V 3/10

(21) Anmeldenummer: **87115492.8**

(22) Anmeldetag: **22.10.87**

(54) **Elektronisches, berührungslos arbeitendes Schaltgerät.**

(30) Priorität: **30.10.86 DE 3637028**
**11.11.86 DE 3638409**

(43) Veröffentlichungstag der Anmeldung:
**04.05.88 Patentblatt 88/18**

(45) Bekanntmachung des Hinweises auf die Patenterteilung:
**28.08.91 Patentblatt 91/35**

(84) Benannte Vertragsstaaten:
**CH DE FR GB LI SE**

(56) Entgegenhaltungen:
**CH-A- 488 279        DE-A- 2 461 169**
**DE-A- 2 704 622        DE-A- 3 244 449**
**DE-C- 3 220 111        FR-A- 2 582 411**

(73) Patentinhaber: **i f m electronic gmbh**
**Teichstrasse 4**
**W-4300 Essen 1(DE)**

(72) Erfinder: **Schramm, Peter**
**Wiesentalstrasse 3**
**W-7996 Meckenbeuren(DE)**

(74) Vertreter: **Gesthuysen, Hans Dieter, Dipl.-Ing.**
**et al**
**Patentanwälte Gesthuysen + von Rohr**
**Huyssenallee 15 Postfach 10 13 33**
**W-4300 Essen 1(DE)**

## Beschreibung

Die Erfindung betrifft einen induktiven Näherungsschalter mit zwei von außen beeinflußbaren, im wesentlichen in einem gemeinsamen magnetischen Kreis liegenden Spulen, einem die Spulen, einen Oszillatorverstärker und eine Rückkopplung aufweisenden Oszillator, einem dem Oszillator nachgeschalteten Schaltverstärker und einem von den Spulen über den Oszillator und den Schaltverstärker steuerbaren elektronischen Schalter, z. B. einem Transistor, einem Thyristor oder einem Triac (vgl. die deutsche offenlegungsschrift DE-A-24 61 169).

Induktive Näherungsschalter der beschriebenen Art sind kontaktlos ausgeführt und werden in zunehmendem Maße anstelle von elektrischen, mechanisch betätigten Schaltgeräten, die kontaktbehaftet ausgeführt sind, in elektrischen Meß-, Steuer- und Regelkreisen verwendet. Mit solchen Näherungsschaltern wird indiziert, ob sich das Beeinflussungselement, für das der Näherungsschalter sensitiv ist, dem Näherungsschalter hinreichend weit genähert hat. Hat sich nämlich das Beeinflussungselement, für das der entsprechende Näherungsschalter sensitiv ist, dem Oszillator hinreichend weit genähert, so steuert der Oszillator den elektronischen Schalter um; bei einem als Schließer ausgeführten Schaltgerät wird der zunächst nichtleitende elektronische Schalter nunmehr leitend, während bei einem als Öffner ausgeführten Schaltgerät der zunächst leitende elektronische Schalter nunmehr sperrt.

Wesentlicher Bestandteil von induktiven Näherungsschaltern der zuvor beschriebenen Art ist der von außen beeinflußbare Oszillator.

Bei den üblichen induktiven Näherungsschaltern gilt für den Oszillator, solange ein Metallteil einen vorgegebenen Abstand noch nicht erreicht hat, $K \cdot V = 1$ mit $K$ = Rückkopplungsfaktor und $V$ = Verstärkungsfaktor, d. h. der Oszillator schwingt. Erreicht das entsprechende Metallteil den vorgegebenen Abstand, so führt die zunehmende Bedämpfung des Oszillators zu einer Verringerung des Verstärkerfaktors $V$, so daß $K \cdot V < 1$ wird, d. h. der Oszillator hört auf zu schwingen (bzw. die Amplitude der Oszillatorschwingung unterschreitet einen vorgegebenen Schwellwert).

Übliche induktive Näherungsschalter, die dadurch ansprechen, daß bei schwingendem Oszillator das elektromagnetische Wechselfeld in dem Metallteil, das als Beeinflussungselement verwendet wird, dämpfend wirkende Wirbelströme induziert, sind noch unter verschiedenen Gesichtspunkten verbesserungsbedürftig:

Einerseits muß die ohne angenähertes Metallteil vorhandene Dämpfung möglichst gering sein, damit die beim Annähern des Metallteils an den Näherungsschalter durch Wirbelströme auftretende Dämpfung ausgewertet werden kann. D. h., daß die üblichen Näherungsschalter nicht ohne weiteres so ansprechempfindlich sind, wie dies wünschenswert ist. Insbesondere dürfen die üblichen Näherungsschalter nicht allseitig metallisch geschlossen sein und können solche induktiven Näherungsschalter nicht durch dämpfendes paramagnetisches Material, z. B. durch Gehäusewände aus Aluminium, hindurch ferromagnetische Beeinflussungselemente detektieren. Andererseits sprechen die üblichen induktiven Näherungsschalter sowohl auf Beeinflussungselemente aus paramagnetischem Material als auch auf solche aus ferromagnetischem Material an.

Der Erfindung liegt nun die Aufgabe zugrunde, einen induktiven Näherungsschalter anzugeben, der besonders ansprechempfindlich ist und der vorzugsweise durch paramagnetisches Material ferromagnetische Beeinflussungselemente detektieren kann oder vorzugsweise nur auf paramagnetisches Material, also nicht auf ferromagnetisches Material anspricht.

Der erfindungsgemäße induktive Näherungsschalter ist nun zunächst und im wesentlichen dadurch gekennzeichnet, daß die beiden Spulen gegensinnig in Reihe geschaltet sind, daß die Reihenschaltung der beiden Spulen als zweite Rückkopplung vorgesehen ist und im Ausgangskreis des Oszillatorverstärkers liegt und daß der Verbindungspunkt der beiden Spulen mit dem Eingang des Oszillatorverstärkers verbunden ist.

Wesentlich für die Lehre der Erfindung ist, daß zwei von außen beeinflußbare Spulen vorgesehen sind, daß die beiden Spulen unterschiedlich, wenn auch geringfügig unterschiedlich beeinflußt werden und daß dadurch, daß die beiden Spulen - wie an sich aus DE-A-32 44 449 bekannt - gegensinnig in Reihe geschaltet sind, ein Differenzsignal gewonnen wird, das besonders gut ausgewertet werden kann, so daß der erfindungsgemäße induktive Näherungsschalter besonders und in besonderer Weise ansprechempfindlich ist. Während bei den üblichen induktiven Näherungsschaltern, von denen die Erfindung ausgeht, die durch das elektromagnetische Wechselfeld in dem als Beeinflussungselement verwendeten Metallteil induzierten Wirbelströme zu einer Dämpfung führen und diese Dämpfung ausgewertet wird, werden bei dem erfindungsgemäßen Näherungsschalter zwei Spulen beeinflußt, und zwar unterschiedlich stark beeinflußt, und wird die Differenz der Auswirkungen dieser Beeinflussungen ausgewertet.

Der erfindungsgemäße induktive Näherungsschalter kann in qualitativ unterschiedlicher Weise sensitiv sein. Bei einer ersten Ausführungsform wird die unterschiedliche Beeinflussung der magnetischen Kreise der beiden Spulen ausgewertet;

diese Ausführungsform ist in der Lage, durch paramagnetisches Material ferromagnetische Beeinflussungselemente zu detektieren. Bei einer zweiten Ausführungsform wird die unterschiedliche Bedämpfung der beiden Spulen ausgewertet; diese Ausführungsform kann so ausgelegt sein, daß sie nur auf Beeinflussungselemente aus paramagnetischem Material anspricht.

Im folgenden werden nun die Lehre der Erfindung sowie Ausgestaltungen und Weiterbildungen der Lehre der Erfindung anhand eines zeichnerisch dargestellten Ausführungsbeispiels näher erläutert, bei dem das Differenzsignal der beiden Spulen durch Beeinflussung des magnetischen Kreises der beiden Spulen gewonnen wird; es zeigt

Fig. 1 ein Blockschaltbild eines erfindungsgemäßen elektronischen, berührungslos arbeitenden Schaltgerätes,

Fig. 2 ein Schaltbild einer bevorzugten Ausführungsform eines Oszillators des elektronischen, berührungslos arbeitenden Schaltgerätes nach Fig. 1 und

Fig. 3 eine bevorzugte Ausführungsform der beiden zu dem Oszillator nach Fig. 2 gehörenden Spulen.

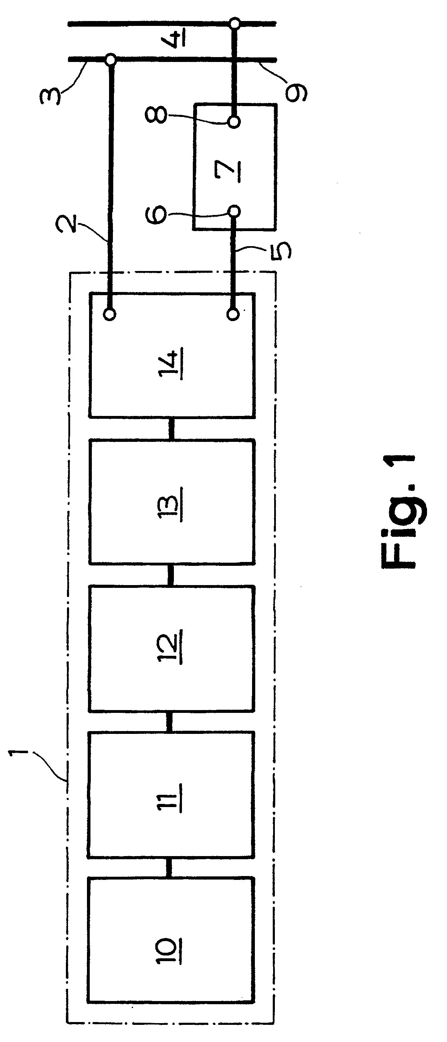

Der in Fig. 1 mit Hilfe eines Blockschaltbildes dargestellte induktive Näherungsschalter 1 arbeitet berührungslos, d. h. er spricht auf ein sich annäherndes, nicht dargestelltes ferromagnetisches Beeinflussungselement an, und ist über einen Außenleiter 2 an einen Pol 3 einer Betriebsspannungsquelle 4 und nur über einen weiteren Außenleiter 5 an einen Anschluß 6 eines Verbrauchers 7 angeschlossen, - während der andere Anschluß 8 des Verbrauchers 7 an den anderen Pol 9 der Betriebsspannungsquelle 4 angeschlossen ist. Mit anderen Worten ist der dargestellte Näherungsschalter 1 in bekannter Weise über insgesamt nur zwei Außenleiter 2, 5 einerseits an die Betriebsspannungsquelle 4 und andererseits an den Verbraucher 7 angeschlossen.

Wie die Fig. 1 zeigt, besteht der dargestellte Näherungsschalter 1 in seinem grundsätzlichen Aufbau aus einem von außen beeinflußbaren Oszillator 10, einem dem Oszillator 10 nachgeschalteten Schaltverstärker 11, einem von dem Oszillator 10 über den Schaltverstärker 11 steuerbaren elektronischen Schalter 12, z. B. einem Transistor, einem Thyristor oder einem Triac, und einer Speiseschaltung 13 zur Darstellung der Speisespannung für den Oszillator 10 und den Schaltverstärker 11. Eingangsseitig ist noch eine Gleichrichterbrücke 14 vorgesehen, weil es sich im dargestellten Ausführungsbeispiel bei der Betriebsspannungsquelle 4 um eine Wechselspannungsquelle handelt.

Die Lehre der Erfindung beschäftigt sich nicht mit der Ausgestaltung des Schaltverstärkers 11 und nicht der Ausgestaltung der Speiseschaltung 13, so daß insoweit die Figuren Details nicht zeigen.

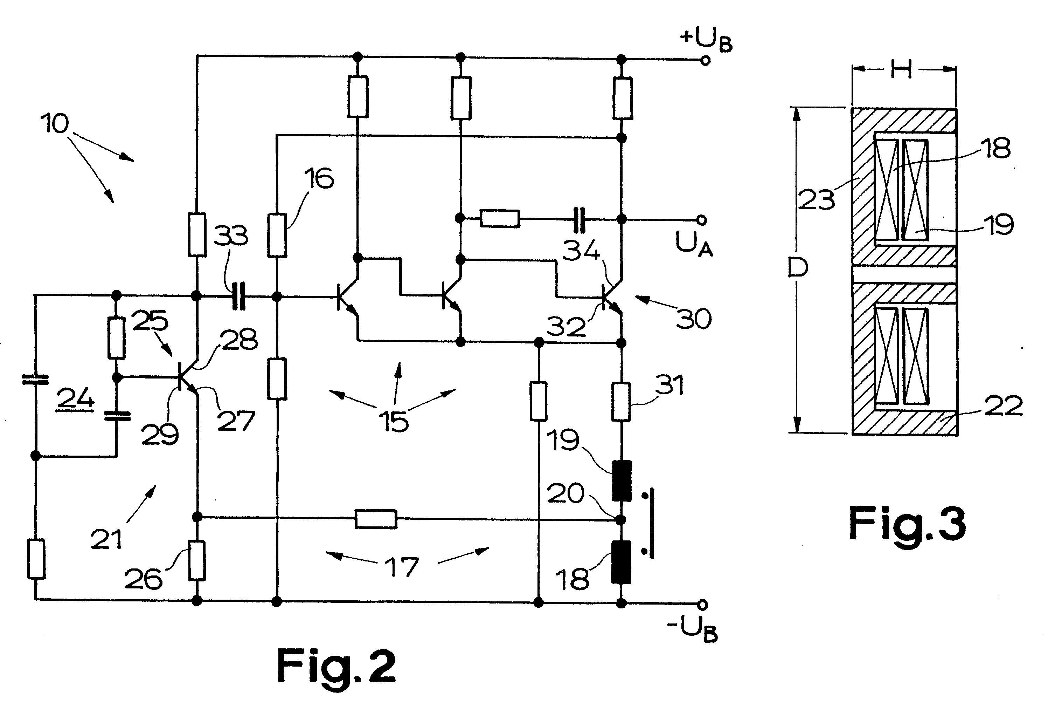

Der Fig. 2 ist nun zu entnehmen, daß der Oszillator 10 zunächst einen Oszillatorverstärker 15 und eine Rückkopplung 16 aufweist und daß eine zweite Rückkopplung 17 vorgesehen ist und die zweite Rückkopplung 17 zwei gegensinnig in Reihe geschaltete, von außen beeinflußbare Spulen 18, 19 aufweist, die Reihenschaltung der Spulen 18, 19 im Ausgangskreis des Oszillatorverstärkers 15 liegt und der Verbindungspunkt 20 der beiden Spulen 18, 19 mit dem Eingang 21 des Oszillatorverstärkers 15 verbunden ist.

Weiter oben ist ausgeführt worden, daß bei dem erfindungsgemäßen Näherungsschalter 1 die magnetischen Kreise der beiden Spulen 18, 19 beeinflußt werden, und zwar unterschiedlich stark beeinflußt werden. Das gilt auch dann, wenn, wie im dargestellten Ausführungsbeispiel, die beiden Spulen 18, 19 in einem im wesentlichen beiden Spulen 18, 19 gemeinsamen magnetischen Kreis liegen, was im dargestellten Ausführungsbeispiel, wie die Fig. 3 zeigt, dadurch realisiert ist, daß beiden Spulen 18, 19 ein gemeinsamer Eisenkern 22 zugeordnet ist. Dabei ist der Eisenkern 22 im Querschnitt E-förmig ausgeführt, nämlich topfförmig ausgeführt, und sind die beiden Spulen 18, 19 in Beeinflussungsrichtung, also in Achsrichtung des topfförmig ausgeführten Eisenkernes 22, hintereinander angeordnet. Der Abstand der Spule 18 zum Boden 23 des Eisenkerns 22, der Abstand der Spule 19 zum Boden 23 des Eisenkerns 22, der Abstand zwischen den beiden Spulen 18 und 19, der Durchmesser D des Eisenkerns 22 und die Höhe des Eisenkerns 22 sind Parameter, mit deren Hilfe die Empfindlichkeit des erfindungsgemäßen Näherungsschalters 1 beeinflußt werden kann. Je nach der Vorgabe einzelner Parameter kann der Fachmann durchschnittlichen Könnens die anderen Parameter im Sinne einer Optimierung der Empfindlichkeit des erfindungsgemäßen elektronischen Schaltgerätes empirisch ermitteln.

Grundsätzlich besteht die Möglichkeit, bei dem erfindungsgemäßen Näherungsschalter die zweite Rückkopplung 17 im Sinne einer Mitkopplung zu schalten. Dargestellt ist jedoch ein Ausführungsbeispiel, bei dem die zweite Rückkopplung 17 im Sinne einer Gegenkopplung geschaltet ist.

Damit bei dem erfindungsgemäßen Näherungsschalter 1 der Oszillator 10 mit einer bestimmten Frequenz, der Eindringtiefe wegen vorzugsweise mit einer Frequenz f = 10 kHz, schwingt, ist, wie Fig. 2 zeigt, der Oszillatorverstärker 15 frequenzselektiv ausgeführt, nämlich mit einem RC-Glied 24 als frequenzbestimmenden Schaltungsteil versehen.

Im übrigen gilt für das in Fig. 2 dargestellte Ausführungsbeispiel des Oszillators 10 des erfindungsgemäßen Schaltgerätes 1, daß der Oszillatorverstärker 15 einen Eingangstransistor 25 aufweist, daß im Emitterkreis des Eingangstransistors 25 ein Emitterwiderstand 26 liegt und der Verbindungspunkt 20 der beiden Spulen 18, 19 mit dem Emitter 27 des Eingangstransistors 25 verbunden ist und daß das RC-Glied 24 an den Kollektor 28 und an die Basis 29 des Eingangstransistors 25 angeschlossen ist. Weiter kann man der Fig. 2 entnehmen, daß im dargestellten Ausführungsbeispiel der Oszillatorverstärker 15 einen Ausgangstransistor 30 aufweist und daß im Emitterkreis des Ausgangstransistors 30 die Reihenschaltung aus einem Emitterwiderstand 31 und den beiden Spulen 18, 19 liegt.

Schließlich zeigt die Fig. 2 noch insoweit ein bevorzugtes Ausführungsbeispiel, als zwischen dem Kollektor 28 des Eingangstransistors 25 und der Basis 32 des Ausgangstransistors 30 ein Koppelkondensator 33 vorgesehen ist und daß zwischen dem Kollektor 34 des Ausgangstransistors 30 und dem dem Kollektor 28 des Eingangstransistors 25 fernen Ende des Koppelkondensators 33 als Rückkopplung 16 ein Rückkopplungswiderstand geschaltet ist.

## Patentansprüche

1. Induktiver Näherungsschalter (1) mit zwei von außen beeinflußbaren, im wesentlichen in einem gemeinsamen magnetischen Kreis liegenden Spulen (18, 19), einem die Spulen, einen Oszillatorverstärker (15) und eine Rückkopplung (16) aufweisenden Oszillator (10), einem dem Oszillator (10) nachgeschalteten Schaltverstärker (11) und einem von den Spulen (18, 19) über den Oszillator (10) und den Schaltverstärker (11) steuerbaren elektronischen Schalter (12), z. B. einem Transistor, einem Thyristor oder einem Triac, **dadurch gekennzeichnet,** daß die beiden Spulen (18, 19) gegensinnig in Reihe geschaltet sind, daß die Reihenschaltung der beiden Spulen (18, 19) als zweite Rückkopplung (17) vorgesehen ist und im Ausgangskreis des Oszillatorverstärkers (15) liegt und daß der Verbindungspunkt (20) der beiden Spulen (18, 19) mit dem Eingang (21) des Oszillatorverstärkers (15) verbunden ist.

2. Induktiver Näherungsschalter nach Anspruch 1, dadurch gekennzeichnet, daß beiden Spulen (18, 19) ein gemeinsamer, im Querschnitt vorzugseise E-förmig, insbesondere topfförmig ausgeführter Eisenkern (22) zugeordnet ist.

3. Induktiver Näherungsschalter nach Anspruch 1 oder 2, dadurch gekennzeichnet, daß die beiden Spulen (18, 19) in Beeinflussungsrichtung hintereinander angeordnet sind.

4. Induktiver Näherungsschalter nach einem der Ansprüche 1 bis 3, dadurch gekennzeichnet, daß die zweite Rückkopplung im Sinne einer Mitkopplung oder im Sinne einer Gegenkopplung geschaltet ist.

5. Induktiver Näherungsschalter nach einem der Ansprüche 1 bis 4, dadurch gekennzeichnet, daß der Oszillator verstärker (15) frequenzselektiv ausgeführt ist, vorzugsweise als frequenzbestimmenden Schaltungsteil ein RC-Glied (24) aufweist.

6. Induktiver Näherungsschalter nach einem der Ansprüche 1 bis 5, wobei der Oszillatorverstärker einen Eingangstransistor aufweist, dadurch gekennzeichnet, daß im Emitterkreis des Eingangstransistors (25) ein Emitterwiderstand (26) liegt und der Verbindungspunkt (20) der beiden Spulen (18, 19) mit dem Emitter (27) des Eingangstransistors (25) verbunden ist.

7. Induktiver Näherungsschalter nach Anspruch 5 oder 6, dadurch gekennzeichnet, daß das RC-Glied (24) an den Kollektor (28) und an die Basis (29) des Eingangstransistors (25) angeschlossen ist.

8. Induktiver Näherungsschalter nach einem der Ansprüche 1 bis 7, dadurch gekennzeichnet, daß der Oszillatorverstärker (15) einen Ausgangstransistor (30) aufweist und vorzugsweise im Emitterkreis des Ausgangstransistors (30) die Reihenschaltung aus einem Emitterwiderstand (31) und den beiden Spulen (18, 19) liegt.

9. Induktiver Näherungsschalter nach einem der Ansprüche 5 bis 7 und nach Anspruch 9, dadurch gekennzeichnet, daß zwischen dem Kollektor (28) des Eingangstransistors (25) und der Basis (32) des Ausgangstransistors (30) ein Koppelkondensator (33) vorgesehen ist und vorzugsweise zwischen dem Kollektor (34) des Ausgangstransistors (30) und dem dem Kollektor (28) des Eingangstransistors (25) fernen Ende des Koppelkondensators (33) als Rückkopplung (16) ein Rückkopplungswiderstand vorgesehen ist.

## Claims

1. An inductive proximity switch (1) with two coils (18, 19) susceptible to external influence, basically included in a common magnetic circuit, an oscillator (10) including the coils, an oscillator amplifier (15) and a feedback coupling (16), a switching amplifier (11) connected in series with the oscillator (10), and an electronic switch (12), e.g. a transistor, a thyristor or a triac, controllable from the coils (18, 19) via the oscillator (10) and the switching amplifier (11), *characterized in that* the two coils (18, 19) are connected in series opposition, that the series connection of the two coils (18, 19) is provided as a second feedback coupling (17) and is situated in the output circuit of the oscillator amplifier (15), and that the point of connection (20) of the two coils (18, 19) is connected to the input (21) of the oscillator amplifier (15).

2. An inductive proximity switch according to Claim 1, *characterized in that* a common iron core (22), preferably E-shaped in section and particularly of pot-shaped construction, is associated with the two coils (18, 19).

3. An inductive proximity switch according to Claim 1 or 2, *characterized in that* the two coils (18, 19) are arranged one behind the other in the direction of influence.

4. An inductive proximity switch according to one of Claims 1 to 3, *characterized in that* the second feedback coupling is connected as a positive feedback or as a negative feedback.

5. An inductive proximity switch according to one of Claims 1 to 4, *characterized in that* the oscillator amplifier (15) possesses an RC link (24) as the frequency-determining component of the circuit.

6. An inductive proximity switch according to one of Claims 1 to 5 in which the oscillator amplifier possesses an input transistor, *characterized in that* an emitter resistor (26) forms part of the emitter circuit of the input transistor (25) and the connection point (20) of the two coils (18, 19) is connected to the emitter (27) of the input transistor (25).

7. An inductive proximity switch according to Claim 5 or 6, *characterized in that* the RC link (24) is connected to the collector (28) and to the base (29) of input transistor (25).

8. An inductive proximity switch according to one of Claims 1 to 7, *characterized in that* the oscillator amplifier (15) possesses an output transistor (30), and the series circuit of an emitter resistance (31) and the two coils (18, 19) preferably forms part of the emitter circuit of output transistor (30).

9. An inductive proximity switch according to one of Claims 5 to 7 and Claim 8 , *characterized in that* a coupling capacitor (33) is provided between collector (28) of input transistor (25) and base (32) of output transistor (30), and that a feedback resistor is preferably connected as feedback coupling (16) between collector (34) of output transistor (30) and the side of coupling capacitor (33) remote from collector (28) of input transistor (25).

**Revendications**

1. Interrupteur inductif de proximité (1) comportant deux bobines (18,19) qui peuvent être influencées de l'extérieur et sont situées essentiellement dans un circuit magnétique commun, un oscillateur (10) comportant les bobines, un amplificateur (15) et une boucle de réaction (16), un amplificateur de commutation (11) branché en aval de l'oscillateur (10) et un interrupteur électronique (12), par exemple un transistor, un thyristor ou un triac, pouvant être commandé par les bobines (18,19) par l'intermédiaire de l'oscillateur (10) et de l'amplificateur de commutation (11), caractérisé en ce que les deux bobines (18,19) sont branchées en série, en des sens opposés et que le montage série des bobines (18,19) est prévu en tant que seconde boucle de réaction (17) et situé dans le circuit de sortie de l'amplificateur (15) de l'oscillateur, et que le point de jonction (20) des deux bobines (18,19) est raccordé à l'entrée (21) de l'amplificateur (15) de l'oscillateur.

2. Interrupteur inductif de proximité selon la revendication 1, caractérisé en ce qu'un noyau de fer commun (22), qui possède de préférence une section transversale en forme de E et est réalisé notamment en forme de pot, est associé aux deux bobines (18,19).

3. Interrupteur inductif de proximité selon la revendication 1 ou 2, caractérisé en ce que les deux bobines (18,19) sont disposées l'une derrière l'autre dans la direction d'influence.

4. Interrupteur inductif de proximité selon l'une des revendications 1 à 3, caractérisé en ce que la seconde boucle de réaction est branchée dans le sens d'un couplage à rétroaction ou dans le sens d'un couplage à contreréaction.

5. Interrupteur inductif de proximité selon l'une des revendications 1 à 4, caractérisé en ce que l'amplificateur (15) de l'oscillateur est réalisé de manière à être sélectif du point de vue des fréquences et comporte de préférence un circuit RC (24) en tant que partie de circuit déterminant la fréquence.

6. Interrupteur inductif de proximité selon l'une des revendications 1 à 5, dans lequel l'amplificateur de l'oscillateur possède un transistor d'entrée, caractérisé en ce qu'une résistance d'émetteur (26) est située dans le circuit d'émetteur du transistor d'entrée (25) et que le point de jonction (20) des deux bobines (18,19) est raccordé à l'émetteur (27) du transistor d'entrée (25).

7. Interrupteur inductif de proximité selon la revendication 5 ou 6, caractérisé en ce que le circuit RC (24) est raccordé au collecteur (28) et à la base (29) du transistor d'entrée (25).

8. Interrupteur de proximité selon l'une des revendications 1 à 7, caractérisé en ce que l'amplificateur (15) de l'oscillateur possède un transistor de sortie (30) et que le montage série formé d'une résistance d'émetteur (31) et des deux bobines (18,19) est situé de préférence dans le circuit d'émetteur du transistor de sortie (30).

9. Interrupteur inductif de proximité selon l'une des revendications 5 à 7 et la revendication 9, caractérisé en ce qu'un condensateur de couplage (33) est prévu entre le collecteur (28) et le transistor d'entrée (25) et la base (32) du transistor de sortie (30) et qu'une résistance de réaction est prévue, en tant que boucle de réaction (16), de préférence entre le collecteur (34) et le transistor de sortie (30) et l'extrémité du condensateur de couplage (33), éloignée du collecteur (28) du transistor d'entrée (25).

Fig. 1

**Fig.2**

**Fig.3**

EP 0 265 844 B1